# EUROPÄISCHE PATENTANMELDUNG

(11) **EP 0 583 027 A1**
(43) Veröffentlichungstag der Anmeldung: **16.02.1994**
(21) Anmeldenummer: 93202244.5
(22) Anmeldetag: 29.07.1993
(51) Int. Cl.: H04H 1/00, H03J 1/00

(54) **Schaltungsanordnung zur Bestimmung der Feldstärke von FM-Sendern**

(30) Priorität: 08.08.1992 DE 4226346
(71) Anmelder: Philips Patentverwaltung GmbH, 22335 Hamburg (DE); Philips Electronics N.V., 5621 BA Eindhoven (NL)
(72) Erfinder: Lünter, Heinz, c/o Philips Patentverwaltung GmbH, D-20097 Hamburg (DE)
(74) Vertreter: von Laue, Hanns-Ulrich, Dipl.-Ing.

(57) **Zusammenfassung**

Bei einer Schaltungsanordnung für einen FM-Empfänger mit einem ZF-Demodulator ist zur möglichst schnellen Bestimmung der Feldstärke von FM-Sendern vorgesehen, daß das Ausgangssignal des FM-Demodulators (1) einem Komparator (5), dessen eine niedrige oder eine hohe Amplitude annehmen kann, zugeführt wird, dem eine Integratorstufe (9, 10 und 11) nachgeschaltet ist, deren Ausgangssignal nur dann hohe Amplitude aufweist, wenn das Ausgangssignal des ZF-Demodulators (1) zur Feldstärkeauswertung geeignet ist.

## Beschreibung

Die Erfindung betrifft eine Schaltungsanordnung für einen FM-Empfänger mit einem ZF-Demodulator zur Bestimmung der Feldstärke von FM-Sendern, insbesondere für einen FM-Empfänger, der die Signale des Radio Daten Systems auswertet.

Bei derartigen Empfängern besteht das Problem, das während ein erster Sender empfangen wird, die Qualität, d.h. insbesondere die Feldstärke anderer Sender überprüft werden soll. Selbstverständlich soll dabei der Empfang des ersten Senders nur möglichst kurzzeitig unterbrochen werden, so daß diese Unterbrechung im Idealfall nicht hörbar ist. Diese Problematik spielt insbesondere bei solchen Empfängern eine Rolle, die die RDS-Signale, die die meisten FM-Sender ausgestrahlen, auswerten. Anhand dieser RDS-Signale erkennt der Empfänger mögliche Alternativfrequenzen, d.h. also mögliche andere FM-Sender, die das gleiche Programm auf anderen Frequenzen senden und auf die gegebenenfalls umgeschaltet werden kann, wenn der gerade empfangene Sender in seiner Empfangsqualität, d.h. insbesondere seiner Feldstärke, zu schlecht wird.

Diese Problematik wird noch dadurch verschärft, daß der FM-Empfänger für die kurzzeitige Umschaltung auf einen anderen FM-Sender eine gewisse Zeit braucht, wobei die Länge dieser Zeitspanne davon abhängt, wie groß die Frequenzdifferenz zwischen dem empfangenen ersten Sender und dem anderen Sender, dessen Feldstärke überprüft werden soll, ist. Da diese aber nicht immer bekannt ist bzw. nicht ausgewertet wird, muß in jedem Falle vom maximalen Frequenzsprung ausgegangen werden, so daß die Wartezeit vom Einstellen der Frequenz des zu überprüfenden Senders bis zur möglichen Auswertung von dessen Feldstärke immer so ausgelegt ist, als ob ein großer Frequenzsprung stattgefunden hätte. Dies bedeutet aber, daß diese Wartezeit immer relativ lang ist.

Es ist Aufgabe der Erfindung, eine Schaltungsanordnung anzugeben, die diese Problematik umgeht und eine möglichst schnelle Auswertung der Feldstärke eines zu überprüfenden FM-Senders gestattet.

Diese Aufgabe ist erfindungsgemäß dadurch gelöst, daß das Ausgangssignal des FM-Demodulators einem Komparator, dessen Ausgangssignal eine niedrige oder eine hohe Amplitude annehmen kann, zugeführt wird, dem eine Integratorstufe nachgeschaltet ist, deren Ausgangssignal nur dann hohe Amplitude aufweist, wenn das Ausgangssignal des ZF-Demodulators zur Feldstärkeauswertung geeignet ist.

Das Ausgangssignal des ZF-Demodulators wird also in einem Komprator mit einem konstanten Signal verglichen, so daß der Komparator ein Ausgangssignal mit hoher Amplitude liefert, wenn das Ausgangssignal des ZF-Demodulators bezüglich seiner Amplitude oberhalb derjenigen des Vergleichssignals liegt. Liegt die Amplitude des Ausgangssignals des ZF-Demodulators unterhalb der Amplitude des Vergleichssignals, liefert die Vergleichsstufe ein Ausgangssignal mit der niedrigen Amplitude.

Um in diesem Ausgangssignal immer noch vorhandene Spannungsspitzen, d.h. also Zeiten, in denen das Ausgangssignal kurzzeitig die hohe Amplitude annimmt, während des Abstimmungsvorgangs abzuschalten, ist dem Komparator eine Integratorstufe nachgeschaltet, welche das Ausgangssignal des Komparators glättet, so daß die Amplitude des Ausgangssignals der Integratorstufe unmittelbar angibt, wann die Amplitude des Ausgangssignals des ZF-Demodulators proportional zur Feldstärke desjenigen FM-Senders ist, auf den der FM-Empfänger neu eingestellt wurde. Das Ausgangssignal der Integratorstufe gibt also quasi an, wann sich der FM-Empfänger auf den neuen FM-Sender "eingeschwungen" hat und wann das Ausgangssignal des ZF-Demodulators sich eingeschwungen hat und zur Feldstärkeauswertung herangezogen werden kann.

Mit dieser Schaltungsanordnung wird erreicht, daß nach der minimal möglichen Zeit nach Abstimmung auf einen neuen FM-Sender dessen Feldstärke gemessen werden kann. Insbesondere nur bei kleinen Frequenzsprüngen wird das Ausgangssignal des Integrators sehr schnell wieder ein gültiges Ausgangssignal des ZF-Demodulators signalisieren, so daß sehr schnell eine Auswertung der Feldstärke erfolgen kann. In der Praxis kann hierdurch insbesondere bei RDS-Empfängern eine erhebliche Verkürzung der Wartezeit erreicht werden, die während der Überprüfung der Feldstärke von alternativen FM-Sendern erforderlich ist, da nicht mehr von einem maximalen Frequenzsprung ausgegangen werden muß, sondern nur diejenige Wartezeit anfällt, die bei dem tatsächlich vorliegenden Frequenzsprung erforderlich ist.

Nach einer Ausgestaltung der Erfindung ist vorgesehen, daß zur Feldstärkeauswertung ein Mikroprozessor vorgesehen ist, dem das Ausgangssignal der Integratorstufe an einem ersten Eingang und das Ausgangssignal des ZF-Demodulators über einen A/D-Umsetzer an einem zweiten Eingang zugeführt wird, und daß der Mikroprozessor eine Auswertung der Amplitude des ihm am zweiten Eingang zugeführten Signals nur während derjenigen Zeiten vornimmt, in denen das ihm am ersten Eingang zugeführte Signal die hohe Amplitude aufweist.

Dem Mikroprozessor kann das Ausgangssignal der Integratorstufe unmittelbar zugeführt werden und er kann dieses unmittelbar auswerten. Sobald dieses Signal die hohe Amplitude erreicht, signalisiert dies dem Mikroprozessor, daß das ihm am zweiten Eingang über einen A/D-Umsetzer zugeführte Ausgangssignal des ZF-Demodulators gültig ist und daß dessen Wert zur Bestimmung der Feldstärke desjenigen Senders herangezogen werden kann, auf den der FM-Empfänger eingestellt ist bzw. neu eingestellt wurde.

Anhand der Zeichnung wird ein Ausführungsbeispiel der Erfindung näher erläutert.

Es zeigen:
Fig. 1 ein Prinzipschaltbild der erfindungsgemäßen Schaltungsanordnung und
Fig. 2 ein Zeitdiagramm zweier Signale der Schaltungsanordnung gemäß Fig. 1.

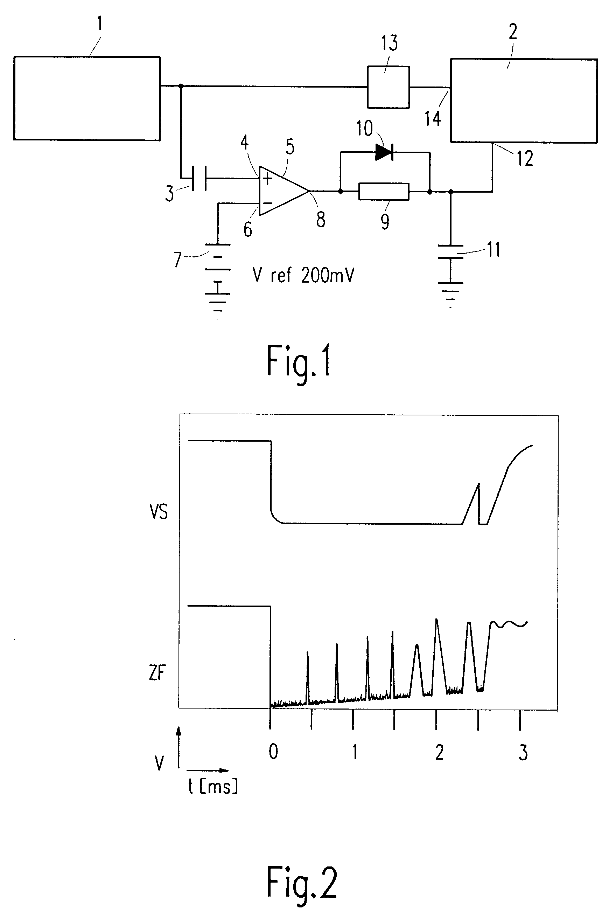

Eine in Fig. 1 dargestellte Schaltungsanordnung für einen FM-Empfänger ist zur Bestimmung der Feldstärke von FM-Sendern vorgesehen, auf die der FM-Empfänger eingestellt ist bzw. neu eingestellt wurde.

Der im übrigen in der Fig. 1 nicht dargestellte FM-Empfänger weist einen ZF-Demodulator 1 auf, dessen Ausgangssignal einem A/D-Umsetzer in den Mikroprozessor 2 und nachfolgend einem in der Fig. 1 mit 2 bezeichneten Mikroprozessor an einem zweiten Eingang 14 zugeführt wird. Der A/D-Umsetzer 13 kann auch in den Mikroprozessor 2 integriert sein.

Das Ausgangssignal des ZF-Demodulators 1 wird ferner über eine Kapazität 3 einem ersten Eingang 4 eines Komparators 5 zugeführt. Einem zweiten Eingang 6 des Komparators 5 wird ein Vergleichssignal zugeführt, das mittels einer in der Fig. 1 schematisch dargestellten Spannungsquelle 7 gewonnen wird.

Das an einem Ausgang 7 der Komparatorstufe 5 zur Verfügung stehende Ausgangssignal wird einer Integratorstufe zugeführt, die aus einem Widerstand 9, einer Diode 10 und einer Kapazität 11 aufgebaut ist.

Der Widerstand 9 ist mit seinem ersten Anschluß mit dem Ausgang 8 des Komparators 5 verbunden und liefert an seinem zweiten Anschluß das Ausgangssignal der Integratorstufe. Dem Widerstand 9 ist eine Diode 10 parallel geschaltet, die anodenseitig mit dem Ausgang der Komparatorstufe 8 verbunden ist. Die Kathode der Diode 10 sowie der zweite Anschluß des Widerstands 9 sind über eine Kapazität 11 auf Bezugspotential geführt. Die Zeitkonstante der Integratorstufe weist vorteilhaft einen Wert von etwa 200 µs auf.

Das Ausgangssignal der Integratorstufe ist einem ersten Eingang 12 des Mikroprozessors 2 zugeführt.

Im folgenden wird anhand der Darstellung in Fig. 2 die Arbeitsweise der Schaltungsanordnung gemäß Fig. 1 näher erläutert.

In Fig. 2 sind zwei Signalverläufe über der Zeit dargestellt. Das untere in der Fig. 2 dargestellte Signal, das mit ZF bezeichnet ist, stellt das Ausgangssignal des ZF-Demodulators 1 gemäß Fig. 1 dar. Das obere in der Fig. mit VS bezeichnete Signal stellt das Ausgangssignal der Vergleichsstufe der Schaltung gemäß Fig. 1 dar.

Das Ausgangssignal ZF der Darstellung gemäß Fig. 2 weist während derjenigen Zeit, in der der FM-Empfänger zunächst noch auf einen empfangenen ersten Sender eingestellt ist, eine hohe Amplitude auf. Zur Kontrolle der Feldstärke eines anderen FM-Senders wird dann der in den Fig. im übrigen nicht dargestellte FM-Empfänger auf dessen Frequenz eingestellt. Dieses benötigt jedoch einige Zeit, was anhand der Darstellung in Fig. 2 insbesondere am Ausgangssignal ZF des ZF-Demodulators daran zu erkenn ist, daß die Amplitude von dessen Ausgangssignal zunächst stark schwankende Werte annimmt. Nach etwa 3 ms hat sich dessen Ausgangssignal beruhigt und kann nunmehr zur Auswertung der Feldstärke des neu eingestellten FM-Senders herangezogen werden.

Dies wird dem Mikroprozessor 2 der Schaltungsanordnung gemäß Fig. 2 dadurch signalisiert, daß das ebenfalls in Fig. 2 dargestellte Signal VS der erfindungsgemäßen Schaltungsanordnung nunmehr den hohen Amplitudenwert erreicht. Ab dem Zeitpunkt, zu dem der FM-Empfänger auf den neuen Sender eingestellt wurde, nimmt dieses Signal zunächst eine niedrige Amplitude an, womit dem Mikroprozessor 2 der Anordnung gemäß Fig. 1 mitgeteilt wird, daß das Signal ZF ungültige Werte hat. Zu diesem Zeitpunkt kann anhand dieses Signals die Feldstärke des neu eingestellten FM-Senders noch nicht ausgewertet werden. Erst zu dem Zeitpunkt, zu dem das Signal VS die hohe Amplitude erreicht, kann diese Auswertung stattfinden. In der Darstellung gemäß Fig. 2 ist dieser Zeitpunkt etwa nach 3 ms nach Einstellung auf den neuen Sender erreicht.

Insbesondere die zeitliche Darstellung gemäß Fig. 2 zeigt, daß eine Überprüfung der Feldstärke des neuen FM-Senders bereits nach relativ kurzer Zeit erfolgen kann. Gegenüber den Lösungen nach dem Stand der Technik ist dies ein großer Fortschritt, da hier die tatsächliche Zeit festgestellt wird, die der FM-Empfänger benötigt, um sich auf den neuen Sender einzustellen. Es muß nicht mehr von einem maximalen Frequenzsprung ausgegangen werden, der eine längere Einschwingzeit benötigen würde, als entsprechend der Darstellung gemäß Fig. 2. Die Wartezeit bis zur Auswertung der Feldstärke des neu empfangenen FM-Senders wird also durch die erfindungsgemäße Schaltungsanordnung individuell bestimmt, wobei insbesondere bei relativ kleinen Frequenzsprüngen, wie sie oft auftreten, eine deutliche Verkürzung der Wartezeit erzielt wird.

## Patentansprüche

1. Schaltungsanordnung für einen FM-Empfänger mit einem ZF-Demodulator (1) zur Bestimmung der Feldstärke von FM-Sendern, insbesondere für einen FM-Empfänger, der die Signale des Radio Daten Systems auswertet,
dadurch gekennzeichnet, daß das Ausgangssignal des FM-Demodulators (1) einem Komparator (5), dessen Ausgangssignal eine niedrige oder eine hohe Amplitude annehmen kann, zugeführt wird, dem eine Integratorstufe (9, 10 und 11) nachgeschaltet ist, deren Ausgangssignal nur dann hohe Amplitude aufweist, wenn das Ausgangssignal des ZF-Demodulators (1) zur Feldstärkeauswertung geeignet ist.

2. Schaltungsanordnung nach Anspruch 1,
dadurch gekennzeichnet, daß zur Feldstärkeauswertung ein Mikroprozessor (2) vorgesehen ist, dem das Ausgangssignal der Integratorstufe (9, 10 und 11) an einem ersten Eingang (12) und das Ausgangssignal des ZF-Demodulators über einen A/D-Umsetzer (13) an einem zweiten Eingang (14) zugeführt wird, und daß der Mikroprozessor (2) eine Auswertung der Amplitude des ihm am zweiten Eingang (14) zugeführten Signals nur während derjenigen Zeiten vornimmt, in denen das ihm am ersten Eingang (12) zugeführte Signal die hohe Amplitude aufweist.

3. Schaltungsanordnung nach einem der Ansprüche 1 oder 2,
dadurch gekennzeichnet, daß die Integratorstufe (9, 10 und 11) eine Zeitkonstante von etwa 200 µs aufweist.

4. Schaltungsanordnung nach einem der Ansprüche 1 bis 3,
dadurch gekennzeichnet, daß der Komparator (5) das Ausgangssignal des FM-Demodulators (1) mit einem Vergleichssignal vergleicht, das einen Spannungswert von etwa 200 mV aufweist.

5. Schaltungsanordnung nach einem der Ansprüche 1 bis 4,
dadurch gekennzeichnet, daß die Integratorstufe (9, 10 und 11) einen Widerstand (9), dessen erster Anschluß mit dem Ausgang (8) des Komparators (9) und dessen zweiter Anschluß das Ausgangssignal liefert, eine Diode (10), die parallel zu dem Widerstand (9) geschaltet ist und deren Anode mit dem ersten Anschluß des Widerstands (9) verbunden ist, und eine Kapazität (11) aufweist, die einerseits mit dem zweiten Anschluß des Widerstands (9) und andererseits mit einem Bezugspotential verbunden ist.
